# EUROPEAN PATENT APPLICATION

(11) **EP 4 521 876 A2**
(43) Date of publication of application: **12.03.2025**
(21) Application number: 24197387.4
(22) Date of filing: 29.08.2024
(51) Int. Cl.: H10B 12/00, H10D 30/67

(54) **SEMICONDUCTOR DEVICE**

(30) Priority: 05.09.2023 JP 2023143514
(71) Applicant: Kioxia Corporation, Tokyo 105-0023 (JP)
(72) Inventor: MURASE, Masayuki, Tokyo, 105-0023 (JP); MATSUMOTO, Yuna, Tokyo, 105-0023 (JP); ISHII, Mikiya, Tokyo, 105-0023 (JP); KAI, Naoki, Tokyo, 105-0023 (JP); NODA, Kotaro, Tokyo, 105-0023 (JP); TAKAHASHI, Kensuke, Tokyo, 105-0023 (JP)
(74) Representative: Marks & Clerk LLP

(57) **Abstract**

A semiconductor device may include a channel including an oxide semiconductor layer in a through hole; a first electrode in a first side of the through hole, the first electrode connected to a first side of the channel; a second electrode in a second side of the through hole and connected to a second side of the channel; and an insulating layer having a groove in which the second electrode is accommodated. The insulating layer includes first and second insulating films. The groove extends in a thickness direction. At least a part of the groove has a depth where at least a part of the groove penetrates through the first insulating film and reaches the second insulating film. The second electrode includes a stack of a metal film and a conductive film. The metal film is in contact with at least an inner bottom surface of the groove.

## Description

### CROSS-REFERENCE TO RELATED APPLICATIONS

This application is based upon and claims the benefit of priority from Japanese Patent Application No. 2023-143514, filed September 5, 2023, the entire contents of which are incorporated herein by reference.

### BACKGROUND

### Technical Field

Embodiments described herein relate generally to a semiconductor device.

### Related Art

In recent years, a semiconductor device having a channel made of an oxide semiconductor has been developed. For example, in a dynamic random access memory (DRAM) an oxide semiconductor transistor is applied to a switching transistor of a memory cell.

Furthermore, in a semiconductor memory device, a cylinder-type capacitor and a selector are provided on a substrate including a semiconductor element and the selector is made of an oxide semiconductor.

In such semiconductor memory devices, miniaturization of a circuit would need a wiring structure having a line width in the micron order as an electrode of the oxide semiconductor, and a barrier metal film and an electrode are stacked as an electrode structure connected to the selector.

### BRIEF DESCRIPTION OF THE DRAWINGS

FIG. 1 is a schematic cross-sectional view illustrating a first embodiment of a semiconductor device.
FIG. 2 is a schematic cross-sectional view illustrating a channel and a peripheral structure in the first embodiment of the semiconductor device.
FIG. 3 is a schematic cross-sectional view illustrating a first region in the first embodiment of the semiconductor device.
FIG. 4 is a schematic cross-sectional view illustrating a second region in the first embodiment of the semiconductor device.
FIG. 5 is a schematic cross-sectional view illustrating an example of a method for manufacturing a semiconductor device.
FIG. 6 is a schematic cross-sectional view illustrating an example of a method for manufacturing a semiconductor device.
FIG. 7 is a schematic cross-sectional view illustrating an example of a method for manufacturing a semiconductor device.
FIG. 8 is a schematic cross-sectional view illustrating an example of a method for manufacturing a semiconductor device.
FIG. 9 is a schematic cross-sectional view illustrating an example of a method for manufacturing a semiconductor device.
FIG. 10 is a schematic cross-sectional view illustrating a state in which a crack occurs in an electrode in a semiconductor device of a comparative example.
FIG. 11 is a schematic cross-sectional view illustrating a second embodiment of a semiconductor device.

### DETAILED DESCRIPTION OF THE INVENTION

Hereinafter, a semiconductor device according to an embodiment will be described in detail with reference to the accompanying drawings. It should be noted that embodiments described below are not intended to limit the present invention. In the following description, the same or similar components may be represented by the same reference numbers, and description thereof may be omitted. In the present specification, for convenience of description, the term "on" or "below" may be used. However, the term "on" or "below" is used to describe a relative position in the drawings, and may be different from up or down in a vertical direction.

In some embodiments, a semiconductor device may include, but is not limited to, a channel comprising an oxide semiconductor layer in a through hole; a first electrode in a first side of the through hole, the first electrode being connected to a first side of the channel; a second electrode in a second side of the through hole, the second electrode being connected to a second side of the channel; and an insulating layer having a groove in which the second electrode is accommodated. The insulating layer may include a first insulating film and a second insulating film. The first insulating film is closer to the channel than the second insulating film. The groove extends in a thickness direction. At least a part of the groove has a depth where at least a part of the groove penetrates through the first insulating film in the thickness direction and reaches the second insulating film. The second electrode includes a metal film and a conductive film stacked on the metal film, the metal film being in contact with at least an inner bottom surface of the groove.

In other embodiments, a semiconductor device may include, but is not limited to, a channel comprising an oxide semiconductor layer in a through hole; a first electrode in a first side of the through hole, the first electrode being connected to a first side of the channel; a second electrode in a second side of the through hole, the second electrode being connected to a second side of the channel; and an insulating layer having a groove in which the second electrode is accommodated. The insulating layer may include a first insulating film and a second insulating film. The first insulating film is closer to the channel than the second insulating film. The second electrode may include a metal film and a conductive film stacked on the metal film. The metal film is in contact with at least an inner bottom surface of the groove. The metal film includes at least one of: a conductive oxide film containing one of titanium oxide, titanium oxynitride, ruthenium oxide, and molybdenum oxide; and a stack of a titanium layer and a titanium nitride layer.

### First Embodiment

Hereinafter, a semiconductor device (semiconductor memory device) according to a first embodiment will be described. The semiconductor device of the present embodiment is, for example, a dynamic random access memory (DRAM), and includes a memory cell array including a plurality of memory cells. Each of the memory cells includes a field-effect transistor (FET) and a capacitor.

The memory cells are arranged in row and column directions to form the memory cell array. A plurality of memory cells may be arranged in an up-down direction, in addition to the row and column directions.

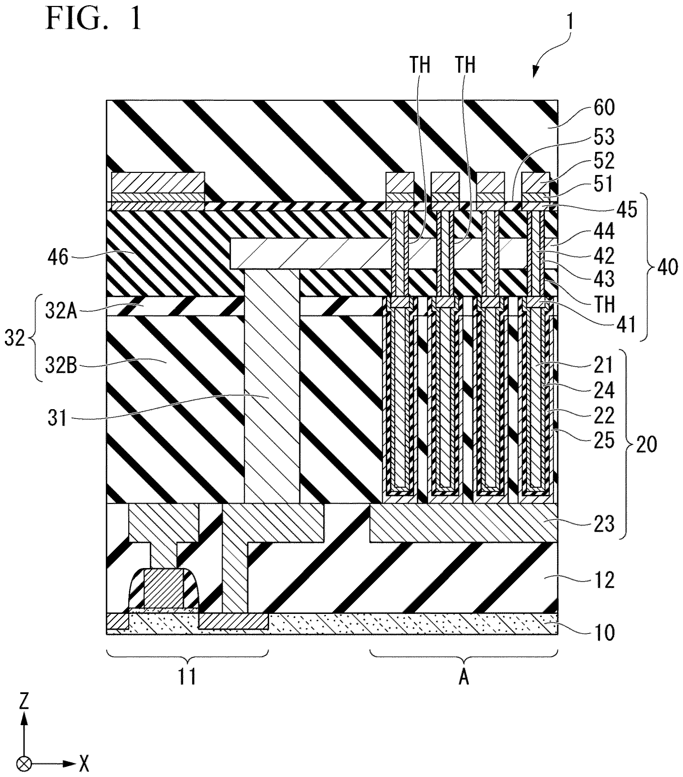

In FIG. 1, a thickness direction of a semiconductor substrate 10 is the up-down direction and is a direction equivalent to a Z direction in FIG. 1. The Z direction along an arrow of FIG. 1 can be described as a +Z direction, and a direction opposite to the +Z direction may be denoted as a -Z direction. One of directions perpendicular to the Z direction is an X direction, and a direction perpendicular to the Z direction and perpendicular to the X direction is referred to as a Y direction. A transverse direction of the row and column directions is the same direction as, for example, the X direction, and a longitudinal direction of the row and column directions is the same direction as the Y direction, for example. In the embodiment of FIG. 1, word lines 44 described below extend along a direction parallel to the X direction, for example.

In the memory cell, a gate of the field-effect transistor is connected to the corresponding word line, and one of a source or a drain of the field-effect transistor is connected to one electrode of the capacitor. The other of the source or the drain of the field-effect transistor is connected to a corresponding bit line. One electrode of the capacitor is connected to one electrode of the field-effect transistor as described above. The other electrode of the capacitor is connected to a power supply line that supplies a prescribed potential. The memory cell stores data by accumulating electric charge in the capacitor from the bit line according to switching of the field-effect transistor by the word line.

Hereinafter, a detailed structure of the semiconductor device 1 will be described.

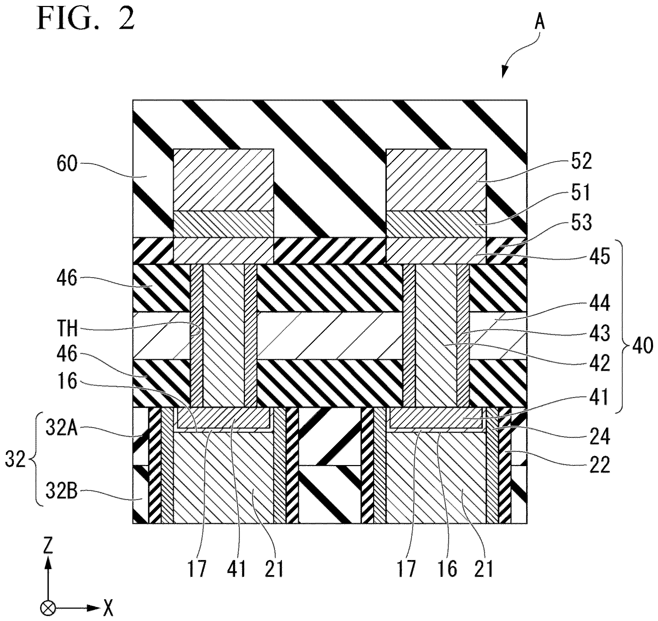

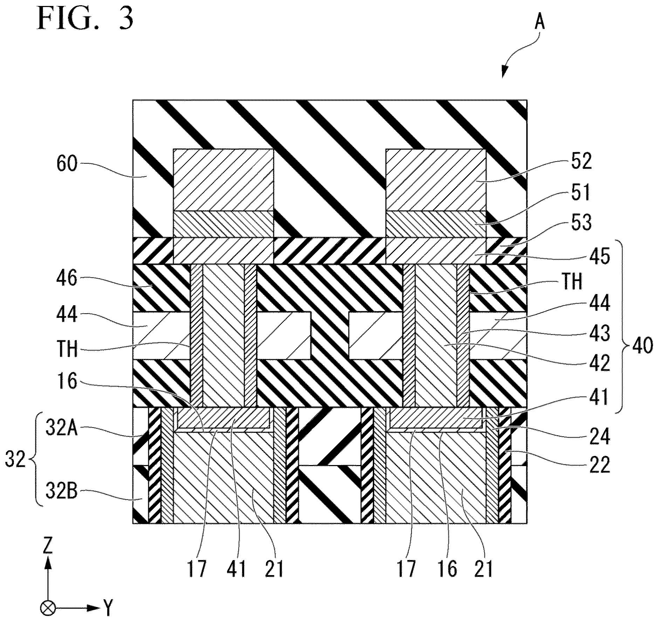

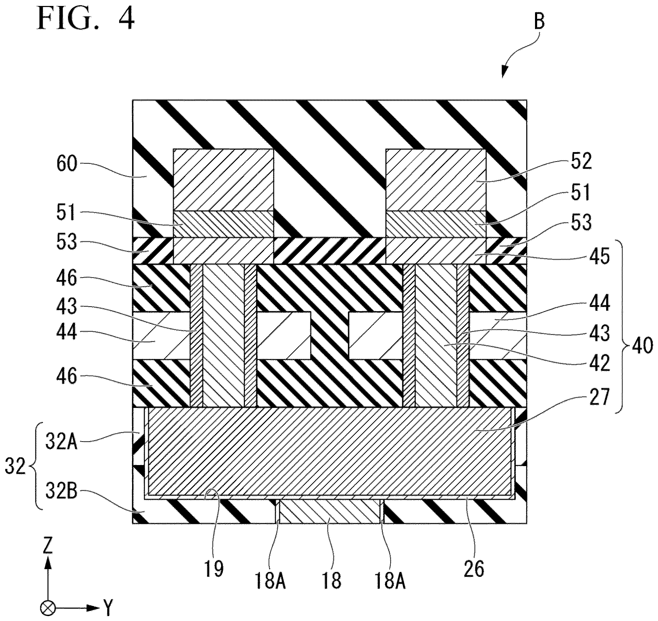

FIG. 1 is a schematic cross-sectional view illustrating a configuration of the semiconductor device 1 of the first embodiment. FIG. 2 is a schematic cross-sectional view illustrating a part of FIG. 1 on an enlarged scale. FIG. 3 is a schematic cross-sectional view of a memory array region A (hereinafter, also abbreviated as an array region A) of the semiconductor device 1, and FIG. 4 is a schematic cross-sectional view of a non-memory array region (hereinafter, also abbreviated as a non-array region) B provided at a position separated from the array region A in the semiconductor device.

### Memory Array Region

As illustrated in FIG. 1, the semiconductor device (semiconductor memory device) 1 has a semiconductor substrate 10 and a semiconductor element 11, and includes a plurality of capacitors 20 and a plurality of field-effect transistors 40 in the memory array region A. Each of the capacitors 20 includes a first capacitor electrode 21, a dielectric 22, a second capacitor electrode 23, a conductor 24, and a conductor 25. The memory array region A is provided on the semiconductor substrate.

An insulating layer 12, an insulating layer 32, an insulating layer (second insulating layer) 46, and an insulating layer 60 are stacked on the semiconductor substrate 10, and the plurality of capacitors 20 in the array region A are provided such that the surroundings thereof are covered with the insulating layer 32. The plurality of field-effect transistors 40 in the array region A are provided such that the surroundings thereof are covered with the insulating layer 32, the insulating layer 46, and the insulating layer 60.

In a region adjacent to the array region A, the semiconductor element 11 is provided in the semiconductor substrate 10 and a portion of the insulating layer 12. In the embodiment of FIG. 1, the semiconductor element 11 is provided in the -X direction of the array region A.

The semiconductor device 1 includes a conductor 31 that penetratees through the insulating layer 32 in a thickness direction (Z direction) thereof to be electrically connected to the semiconductor element 11.

The field-effect transistor 40 includes a lower electrode 41, an oxide semiconductor layer 42, a gate oxide film 43, and an upper electrode (first electrode) 45, and includes the word line 44 connected to the field-effect transistor 40. The above-described conductor 31 is connected to the word line 44.

In the semiconductor device 1, the insulating layer 46 is provided on the insulating layer 32, and the insulating layer 60 is provided on the insulating layer 46 via an insulating film 53. The lower electrode 41 is provided in a portion of the insulating layer 32 close to the insulating layer 46, and the field-effect transistor 40 that extends in the Z direction from the insulating layer 46 to the insulating layer 60 is provided. A plurality of field-effect transistors 40 are formed at prescribed intervals in the X direction and the Y direction of FIG. 1.

The word line 44 is provided to extend in the X direction and the Y direction in the insulating layer 46, and the word line 44 is provided to be connected to the plurality of field-effect transistors 40 arranged in the X direction and the Y direction.

The upper electrode 45 is disposed to be in the same layer as the insulating film 53, and a barrier metal 51 and a landing pad 52 are provided on the upper electrode 45.

The semiconductor substrate 10 is a substrate formed of, for example, single-crystal silicon.

The semiconductor element 11 is a metal-oxide-semiconductor field-effect transistor (MOSFET) formed on the semiconductor substrate 10, but may be other semiconductor elements. The semiconductor element 11 constitutes, for example, a semiconductor integrated circuit.

The first capacitor electrode 21, the dielectric 22, the second capacitor electrode 23, the conductor 24, and the conductor 25 constitute the capacitor 20. The capacitor 20 is a constituent element of the memory cell. In FIG. 1, only four capacitors 20 are illustrated. The number of capacitors 20 can be changed freely.

The capacitor 20 of the present embodiment is a three-dimensional capacitor such as a so-called pillar-type capacitor or a cylindrical capacitor. The capacitor 20 includes the conductor 24, the dielectric 22, and the conductor 25 between the first capacitor electrode 21 and the second capacitor electrode 23. The second capacitor electrode 23 is provided in the insulating layer 12 at a position close to the insulating layer 32.

In the configuration illustrated in FIG. 1, the conductor 24 is formed to cover a peripheral surface and a bottom surface of the first capacitor electrode 21, and the second capacitor electrode 23 and the conductor 25 are provided to further cover a peripheral surface and a bottom surface of the conductor 24.

The capacitor 20 accumulates electric charge between the first capacitor electrode 21 and the second capacitor electrode 23.

The insulating layer 32 is an insulator that electrically insulates the capacitors 20 in a layer where the capacitors 20 are formed.

The first capacitor electrode 21 contains, for example, a material such as amorphous silicon. The second capacitor electrode 23, the conductor 24, and the conductor 25 contain, for example, a material such as tungsten (W) or titanium nitride (TiN). The dielectric 22 is an insulator and contains, for example, a material such as hafnium oxide.

The lower electrode 41, the oxide semiconductor layer 42, the gate oxide film 43, the word line 44, and the upper electrode 45 constitute the field-effect transistor 40. The field-effect transistor 40 extends in the Z direction above the capacitor 20. The field-effect transistor 40 is a constituent element of the memory cell. In FIG. 1, only four field-effect transistors 40 paired with the four capacitors 20 are illustrated. The number of field-effect transistors 40 can be changed freely depending on the number of capacitors 20.

The lower electrode 41 is provided on the first capacitor electrode 21 and is electrically connected to the first capacitor electrode 21. The lower electrode 41 contains, for example, metal oxide such as indium tin oxide (ITO).

The insulating layer 46 is an insulator that is provided in a layer where the oxide semiconductor layer 42 and the like are formed. The insulating layer 46 is made of, for example, silicon oxide (SiO₂) formed through means such as CVD using a gas such as tetraethoxysilane (TEOS).

The insulating layer 32 includes a first insulating film 32A on a side in contact with the insulating layer 46, and the other portion is a second insulating film 32B. The first insulating film 32A contains silicon and nitrogen. As an example, the first insulating film 32A is made of silicon nitride (SiN). The first insulating film 32A is preferably a film that serves as a stopper in a case where a through hole TH described below is formed in the insulating layer 46. The second insulating film 32B is made of silicon oxide (SiO₂).

The conductor 24 and the dielectric 22 around the first capacitor electrode 21 penetrate through the first insulating film 32A and the second insulating film 32B in the Z direction to extend to an interface position of the insulating layer 12. While the first capacitor electrode 21 also extends to penetrate through the insulating layer 32 in the Z direction, an upper end of the first capacitor electrode 21 is positioned slightly under the interface position between the first insulating film 32A and the insulating layer 46.

A recessed groove 16 having a given depth from the interface position between the first insulating film 32A and the insulating layer 46 in a film thickness direction of the first insulating film 32A is formed, and a metal film 17 and the lower electrode 41 are formed in the recessed groove 16. Since a film thickness of the metal film 17 is sufficiently thin with respect to the width and the depth of the recessed groove 16, the metal film 17 is provided to cover a bottom surface and inner side surfaces of the recessed groove 16 thin. Accordingly, most of the recessed groove 16 on the array region side is filled with the lower electrode 41.

The metal film 17 contains titanium and nitrogen. The metal film 17 is made of conductive nitride such as TiN as an example. The metal film 17 is preferably made of a material functioning as barrier metal.

The oxide semiconductor layer 42 is formed inside the through hole TH formed in the insulating layer 46 between the lower electrode 41 and the upper electrode 45, and extends in a columnar shape in the Z direction. The oxide semiconductor layer 42 is, for example, oxide containing indium (In), gallium (Ga), and zinc (Zn), and is so-called IGZO. The oxide semiconductor layer 42 forms a channel of the field-effect transistor 40. That is, the channel is formed in the through hole TH, one end side (one side) of the channel in the +Z direction is electrically connected to the upper electrode 45, and the other end side (the other side) of the channel in the -Z direction is electrically connected to the lower electrode 41. In other words, the upper electrode 45 is disposed in a first side of the through hole TH, and the lower electrode 41 is disposed in a second side of the through hole TH.

The gate oxide film 43 is provided between the lower electrode 41 and the upper electrode 45 to cover the surroundings of the oxide semiconductor layer 42. The gate oxide film 43 is an insulator and contains, for example, silicon and oxygen. An upper end of the gate oxide film 43 in the +Z direction is in contact with the upper electrode 45, and a lower end of the gate oxide film 43 in the -Z direction is in contact with the lower electrode 41. The gate oxide film 43 is also formed inside the through hole TH. The first insulating film 32A is an insulating film on a side close to the channel, and the second insulating film 32B is an insulating film on a side far from the channel.

The word line 44 forms a word line in the memory cell and forms a gate electrode of the field-effect transistor 40. The word line 44 is, for example, a conductor containing at least one material selected from the group consisting of tungsten (W), titanium (Ti), titanium nitride (TiN), molybdenum (Mo), cobalt (Co), and ruthenium (Ru), and is typically made of tungsten. The word line 44 is an example of a "control electrode" in the present embodiment.

The upper electrode 45 is provided on the oxide semiconductor layer 42. The upper electrode 45 is a conductor containing conductive oxide, and contains, for example, metal oxide such as indium tin oxide (ITO). The upper electrode 45 is an example of a "first electrode" in the present embodiment.

The upper electrode 45 functions as one of a source electrode or a drain electrode of the field-effect transistor 40, and the lower electrode 41 functions as the other of the source electrode or the drain electrode of the field-effect transistor 40.

The insulating film 53 is an insulator that exists in the same layer as the upper electrode 45 and is provided around the upper electrode 45, and electrically insulates a plurality of upper electrodes 45 separated in the X direction and the Y direction. The insulating film 53 contains at least one metal element selected from magnesium (Mg), vanadium (V), chromium (Cr), manganese (Mn), iron (Fe), cobalt (Co), nickel (Ni), and bismuth (Bi), in addition to metal oxide such as indium tin oxide (ITO) similar to the upper electrode 45.

The insulating film 53 is an insulator different from the upper electrode 45, which is a conductor, formed by ion implantation of metal such as magnesium in a process after formation of indium tin oxide or the like in a manufacturing process. That is, the insulating film 53 is formed to physically continue the upper electrode 45 and functions as an insulator through doping (implantation) of metal such as magnesium. In the insulating film 53, the metal that is implanted in a film of metal oxide such as indium tin oxide is not limited to magnesium or the like described above, and is not limited as long as a material increases electrical resistance of the film of metal oxide through implantation in the film of metal oxide to substantially form an insulator.

The insulating layer 60 is an insulator formed on the upper electrode 45. The insulating layer 60 electrically insulates the landing pad 52 and the barrier metal 51 from other landing pads 52 and barrier metals 51 disposed adjacent thereto. The insulating layer 60 contains, for example, silicon and oxygen.

The field-effect transistor 40 generates a prescribed potential difference between the word line 44 functioning as the gate electrode and the source electrode or the drain electrode. With the generation of the potential difference, an electric field is generated in a channel region of the oxide semiconductor layer 42, and a current flows from the source electrode toward the drain electrode. The word line 44 is also referred to as a "control electrode" that generates an electric field in the oxide semiconductor layer 42 forming the channel.

The barrier metal 51 is provided on the upper electrode 45 to cover the upper electrode 45. The barrier metal 51 is made of, for example, a conductor such as tantalum (Ta) or tantalum nitride (TaN). The barrier metal 51 has low oxygen permeability compared to the upper electrode 45, for example.

The landing pad 52 is formed on the barrier metal 51 and functions as the bit line of the memory cell. The landing pad 52 is made of, for example, a conductor such as tungsten (W).

The conductor 31 electrically connects, for example, the memory cell and the semiconductor element 11. The conductor 31 has a function as a so-called via. The conductor 31 is made of, for example, metal such as copper.

### Non-Memory Array Region

While the memory array region A of the semiconductor device 1 illustrated in FIGS. 1 to 3 and the semiconductor element 11 provided in the vicinity thereof have been described above, the non-array region (non-memory array region) B having a cross-sectional structure illustrated in FIG. 4 is provided at a position separated from the memory array region A in the semiconductor device 1. As an example, in a case where a plurality of semiconductor devices 1 are formed on a disk-shaped semiconductor wafer to be adjacent to each other at prescribed intervals, and the semiconductor devices 1 formed adjacent to each other are cut in a chip shape by dicing or the like, the non-array region B corresponds to a region that is cut by dicing. Alternatively, in a case where the semiconductor device 1 is a semiconductor memory device, the non-array region B indicates a region provided separated from the memory array region for recording information. The non-memory array region B is provided on the semiconductor substrate.

In the non-array region B, an electrical characteristic management test circuit and the like for the plurality of semiconductor devices 1 formed on the semiconductor wafer are formed on the semiconductor substrate 10 side.

Also in the non-array region B, as described with reference to FIGS. 1 to 3, a structure in which the insulating layers or the insulating films such as the insulating layer 12, the first insulating film 32A, the second insulating film 32B, the insulating layer 46, the insulating film 53, and the insulating layer 60 are formed on the semiconductor substrate 10 is common.

A structure in which the field-effect transistor 40 is formed over the insulating layer 46, the insulating film 53, and the insulating layer 60 is also common. A structure in which each field-effect transistor 40 includes the oxide semiconductor layer 42, the gate oxide film 43, and the upper electrode 45, and includes the word line 44 connected to the field-effect transistor 40 is also common.

In the non-array region B, a difference from the array region A is that the capacitor 20 provided in the array region A is omitted in the non-memory array region B, and a third electrode (conductive film) 18 is provided alternatively. In addition, in the non-memory array region B, structures of a lower electrode and a recessed groove are different.

As illustrated in FIG. 4, a recessed groove 19 having a depth to penetrate through the first insulating film 32A in a thickness direction thereof and reach the second insulating film 32B is formed to correspond to two field-effect transistors 40 adjacent to each other in the Y direction. In the configuration illustrated in FIG. 4, the recessed groove 19 having a depth greater than the film thickness of the first insulating film 32A is formed.

The recessed groove 19 is preferably formed to have such a depth that at least a part of a bottom surface of the recessed groove 19 reaches the second insulating film 32B. The recessed groove 19 can be formed by etching the first insulating film 32A and the second insulating film 32B by etching such as dry etching or wet etching.

Accordingly, the recessed groove 19 on the non-array region side can be referred to as a dry-etched groove or a wet-etched groove.

A metal film 26 that is in contact with an inner bottom surface and inner side surfaces of the recessed groove 19 is formed on an inner surface side of the recessed groove 19, and a lower electrode (second electrode) 27 made of an electrode film is formed inside the metal film 26. The metal film 26 is made of a material equivalent to the metal film 17 described above and has a film thickness equivalent to the metal film 17.

Since the film thickness of the metal film 26 is sufficiently thin with respect to the width and the depth of the recessed groove 19, the inner bottom surface and the inner side surfaces of the recessed groove 19 are covered with the thin metal film 26, and most of the recessed groove 19 is filled with the lower electrode 27. That is, the lower electrode (second electrode) 27 is accommodated in the recessed groove 19.

In FIG. 4, the oxide semiconductor layer 42 having a columnar shape is formed above the lower electrode 27, and the gate oxide film 43 is formed around the oxide semiconductor layer 42. A structure of a portion where the oxide semiconductor layer 42 and the gate oxide film 43 are provided and a structure above the structure are equivalent to the structures of the memory array region A described above.

In a case where the recessed groove 19 is formed, it is desirable that the groove bottom surface is a plane and is a surface parallel to an XY plane including the X direction and the Y direction as illustrated in FIG. 4. However, if the recessed groove 19 is formed by etching, it is considered that the bottom surface of the recessed groove 19 is a surface inclined with respect to the XY plane or a recessed surface or a protruding surface from a problem with etching accuracy. Even in such a case, it is most desirable that the entire surface or substantially entire surface of the bottom surface of the recessed groove 19 reaches the second insulating film 32B. Meanwhile, it is considered that an objective is likely to be achieved as long as at least a part of the bottom surface of the recessed groove 19 reaches the second insulating film 32B. Here, the objective is that no cracks occur in the lower electrode 27 formed inside the recessed groove 19 during heat treatment in a post-process. Accordingly, at least a part of the bottom surface of the recessed groove 19 should reach the second insulating film 32B.

A third electrode 18 electrically connected to the lower electrode 27 via the metal film 26 is provided in the second insulating film 32B under the recessed groove 19. The third electrode 18 is formed along a through hole penetrating through the second insulating film 32B in the Z direction and is electrically connected to the electrical characteristic management test circuit and the like provided in the non-array region B. A metal layer 18A is formed around the third electrode 18 at a position surrounding a peripheral surface of the third electrode 18.

A lower end of the third electrode 18 is connected to an electronic circuit (not illustrated) for trial conduction, or the like provided on the semiconductor substrate 10.

The third electrode 18 is made of, for example, a metal electrode containing tungsten (W).

In a structure including the lower electrode 27 that penetrates through the first insulating film 32A and reaches the second insulating film 32B as illustrated in FIG. 4, in creating the field-effect transistor 40 above the lower electrode 27, no cracks occur in the lower electrode 27 when heating treatment is performed.

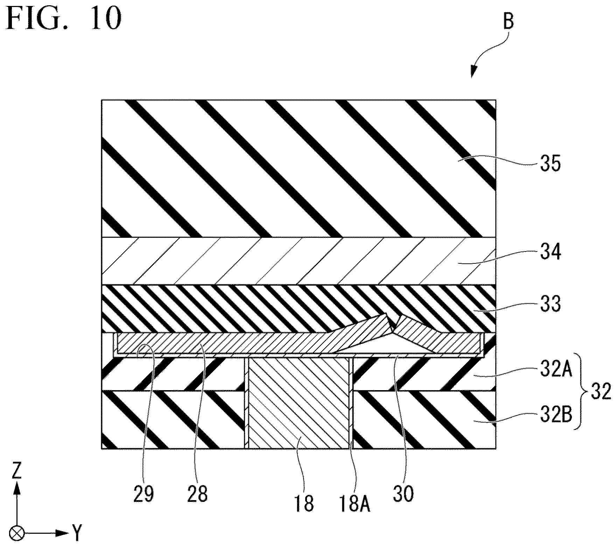

FIG. 10 illustrates a comparative example structure in which a third electrode 18 and a lower electrode 28 are provided with respect to a structure in which the second insulating film 32B and the first insulating film 32A are stacked in the non-memory array region B.

In the comparative example structure of FIG. 10, a recessed groove 29 is formed in the first insulating film 32A, and a metal film 30 and the lower electrode 28 are provided in the recessed groove 29. As illustrated in FIG. 10, a depth of the recessed groove 29 is smaller than the film thickness of the first insulating film 32A.

The above-described structure is employed, and a post-process for forming the field-effect transistor 40 described above on the lower electrode 28 is performed. For example, a first layer 33 by vapor phase growth using pSiH₄, a second layer 34 containing tungsten, a third layer 35 made of a carbon film, and the like are stacked on the first insulating film 32A and the lower electrode 28, and a process such as heating treatment is performed. Then, a crack occurs in the lower electrode 28 as illustrated in FIG. 10.

In contrast, in a structure in which the lower electrode 27 that penetrates through the first insulating film 32A and reaches the second insulating film 32B as illustrated in FIG. 4 is provided, the crack does not occur when the first layer 33, the second layer 34, the third layer 35 illustrated in FIG. 10 are provided and heating treatment is performed in the post-process.

As one of the causes of the occurrence of the crack in the structure illustrated in FIG. 10, the present inventors have estimated that a lot of nitrogen is contained in the metal film 30 made of TiN provided in the bottom portion of the recessed groove 29, and accordingly, part of nitrogen is gasified by heating treatment and expands. It is also considered that an influence of film stress during heating caused by the film types of the first layer 33, the second layer 34, and the third layer 35 used in the post-process is not negligible.

However, if the recessed groove 19 and the lower electrode 27 illustrated in FIG. 4 are employed, it is considered that the occurrence of a crack is suppressed since the bottom surface of the recessed groove 19 reaches the second insulating film 32B, the lower electrode 27 has a sufficient film thickness, and the like.

### Method for Manufacturing Semiconductor Memory Device 1

Next, a method for manufacturing the semiconductor memory device 1 will be described based on the structure of the first embodiment. A method for manufacturing a semiconductor device of the related art can be employed in processes other than processes described below.

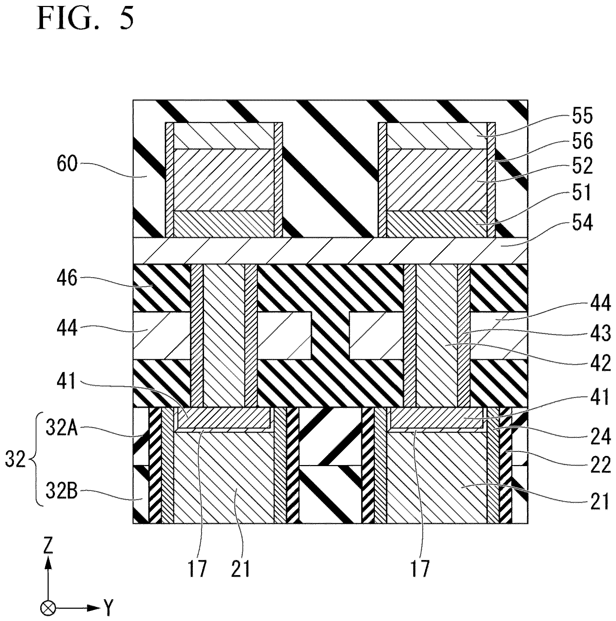

FIG. 5 illustrates a state before the upper electrode 45 and the insulating film 53 are formed on an upper layer of the oxide semiconductor layer 42 and the insulating layer 46. The oxide semiconductor layer 42 and the gate oxide film 43 are formed in the through hole TH formed in the insulating layer 46. A conductor 54 is stacked on an upper layer of the oxide semiconductor layer 42, the gate oxide film 43, and the insulating layer 46. In this case, since the conductor 54 is formed on one surface, a plurality of oxide semiconductor layers 42 are electrically connected via the conductor 54.

In addition, the barrier metal 51, the landing pad 52, a coating 55, and a liner film 56 are formed on the conductor 54. The coating 55 is formed on the landing pad 52. The liner film 56 is formed to surround the barrier metal 51, the landing pad 52, and the coating 55. Although the coating 55 is not illustrated in FIGS. 1 and 2, the coating 55 may be provided similarly to FIG. 5, or a configuration may be made in which no coating 55 is provided.

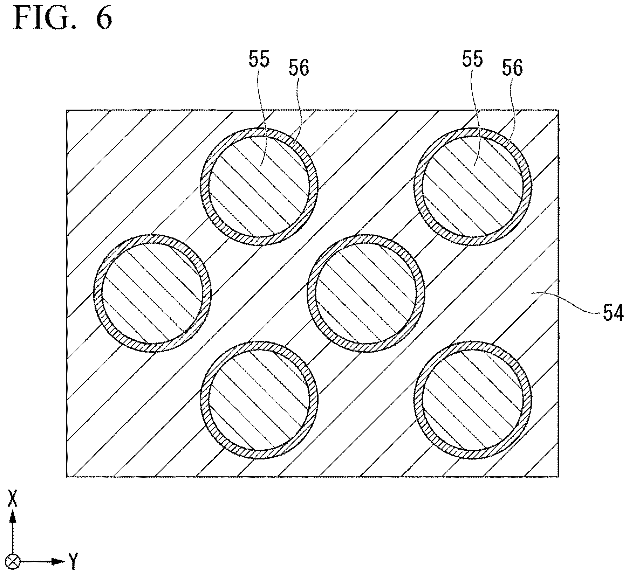

FIG. 6 is a plan view of a semiconductor memory device during manufacturing illustrated in FIG. 5 as viewed from above. The liner film 56 in an annular shape is formed around the coating 55 in a circular shape. The coating 55 and the liner film 56 are provided in a staggered manner in the X direction and the Y direction.

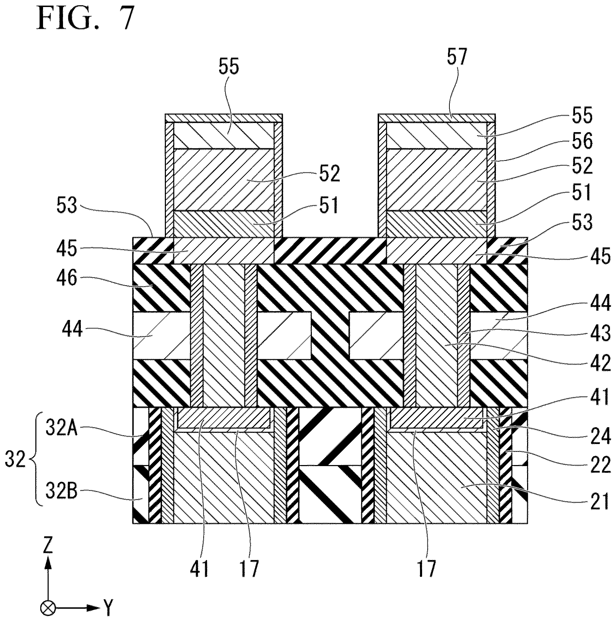

In the state illustrated in FIGS. 5 and 6, a material such as magnesium to be doped (implanted) in the conductor 54 is supplied to perform ion implantation. Accordingly, as illustrated in FIG. 7, the upper electrode 45, the insulating film 53, and a coating 57 are formed. The upper electrode 45 is made of the same material as the conductor 54 without implantation of magnesium or the like. On the other hand, the insulating film 53 is increased in resistance with implantation of magnesium or the like in the conductor 54, and forms an insulator. With this, the adjacent upper electrodes 45 are electrically insulated, and the oxide semiconductor layers 42 are also electrically insulated from each other. The coating 57 is the coating 55 and the liner film 56 in which magnesium or the like is implanted.

Here, the material that is implanted in the conductor 54 may be selected freely as long as the material increases electrical resistance of metal oxide such as indium tin oxide through implantation in the metal oxide to substantially form an insulator. Specifically, the material that is implanted in the conductor 54 has at least one metal element selected from magnesium (Mg), vanadium (V), chromium (Cr), manganese (Mn), iron (Fe), cobalt (Co), nickel (Ni), and bismuth (Bi). Preferably, magnesium (Mg) is implanted in the conductor 54.

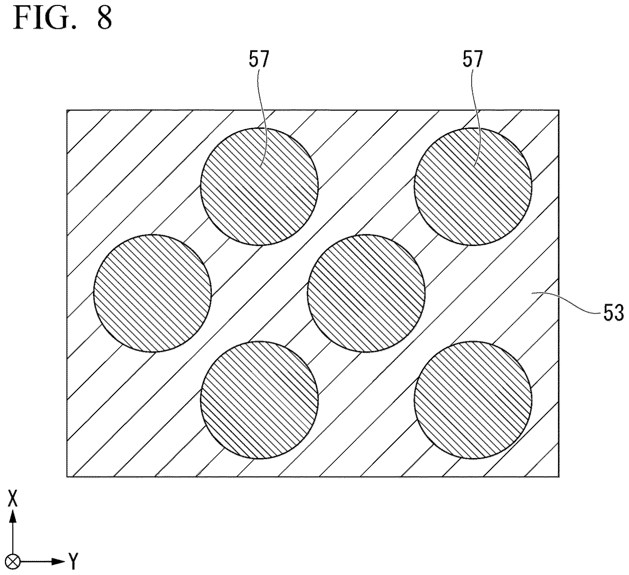

FIG. 8 is a plan view of the semiconductor memory device during manufacturing illustrated in FIG. 7 as viewed from above. The conductor 54 is formed below the coating 57, and the insulating film 53 is formed around the coating 57.

In a state of FIG. 8, since oxygen is supplied to the oxide semiconductor layer 42 and activated, oxygen annealing by heating is performed.

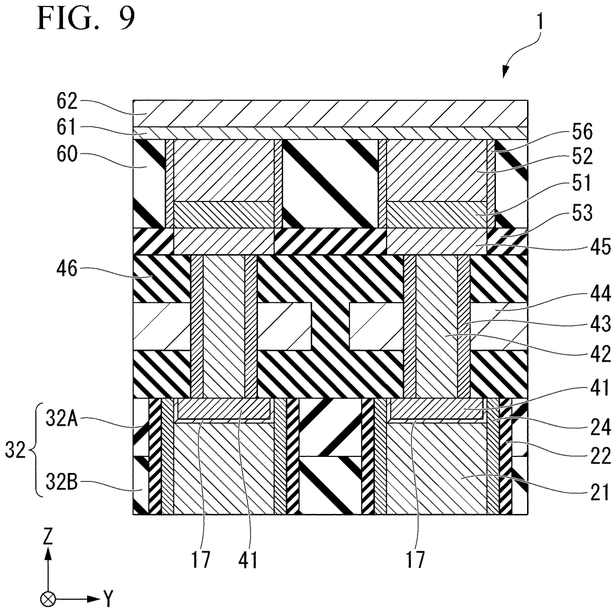

After oxygen annealing is performed in the state of FIG. 8, the coating 55 and the coating 57 are removed, and the insulating layer 60, a first bit line 61, and a second bit line 62 are formed. With this, a semiconductor device (semiconductor memory device) 1 illustrated in FIG. 9 can be manufactured.

In FIG. 9, the first bit line 61 is made of, for example, a conductor such as titanium nitride. The second bit line 62 is made of, for example, a conductor such as tungsten.

### Second Embodiment

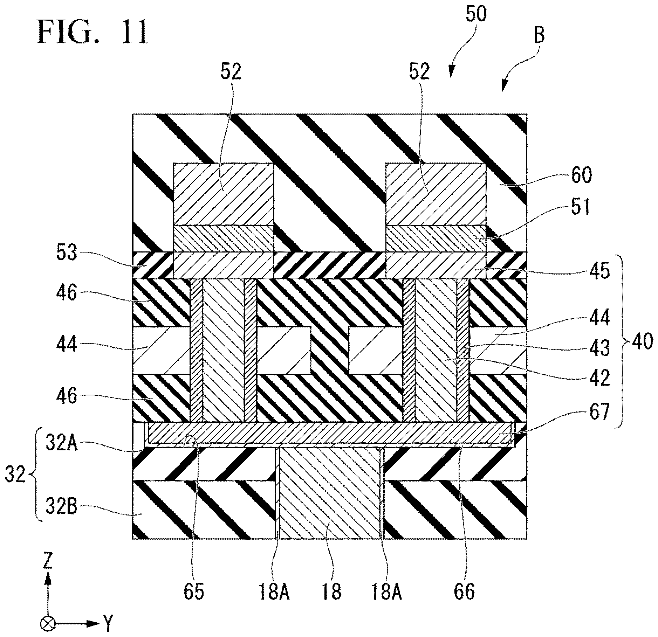

FIG. 11 illustrates a partial cross-sectional view of a semiconductor device (semiconductor memory device) 50 according to a second embodiment.

The semiconductor device 50 according to the second embodiment has a structure equivalent to the semiconductor device 1 of the first embodiment regarding the structure of the memory array region A.

In the semiconductor device 50 according to the second embodiment, the structure of the non-array region B is different from that of the semiconductor device 1 of the first embodiment.

In the non-array region B, a recessed groove 65 is formed in an insulating film 15, and a metal film 66 and a lower electrode 67 are provided in the recessed groove 65. A film thickness and a constituent material of the metal film 66 are equivalent to the film thickness and the constituent material of the metal film 26 illustrated in the first embodiment.

A structure in which the field-effect transistor 40 is provided in the non-array region B is equivalent to the structure of the semiconductor device 1 of the first embodiment.

In the semiconductor device 50, the material that forms the metal film 66 is different from the material that forms the metal film 26 of the semiconductor device 1. A configuration of the lower electrode (second electrode) 67 is also different from the configuration of the lower electrode 27 of the first embodiment.

In the second embodiment, the metal film 66 is made of a conductive oxide film containing one of titanium oxide, titanium oxynitride, ruthenium oxide, and molybdenum oxide or a stacked film of a titanium layer and a titanium nitride layer.

The metal film 66 is formed of the conductive oxide film containing one of titanium oxide, titanium oxynitride, ruthenium oxide, and molybdenum oxide, so that a structure in which no crack occurs in the lower electrode 67 during heating treatment in the post-process can be obtained.

The metal film 66 is formed of the stacked film of the titanium layer and the titanium nitride layer, so that a structure in which no crack occurs in the lower electrode 67 when heating treatment is performed in the post-process can be obtained.

In the second embodiment, the metal film 66 formed in the recessed groove 65 in the insulating film 15 is formed of the conductive oxide film containing one of titanium oxide, titanium oxynitride, ruthenium oxide, and molybdenum oxide or the stacked film of the titanium layer and the titanium nitride layer.

Meanwhile, the metal film 26 that is formed in the recessed groove 19 having a depth to reach the second insulating film 32B formed in the first embodiment may be formed of a conductive oxide film containing one of titanium oxide, titanium oxynitride, ruthenium oxide, and molybdenum oxide or a stacked film of a titanium layer and a titanium nitride layer.

The recessed groove 19 illustrated in FIG. 4 is formed at a depth to reach the second insulating film 32B, and the metal film 26 is made of the above-described material, so that a structure in which no crack occurs in the lower electrode 27 during heating treatment may be made.

The present embodiment has been described with reference to the specific example. However, the present disclosure is not limited to the specific examples. The specific examples to which design changes are made by those skilled in the art as appropriate are encompassed in the scope of the present disclosure as long as the features of the present disclosure are included. The components and the dispositions thereof, the conditions, the shapes, and the like in the specific examples are not limited to those illustrated and may be changed as appropriate. The combination of the components in the specific examples may be changed as appropriate as long as technical contradiction does not occur.

For example, the configuration of the present embodiment is not limited to the semiconductor memory device 1 of the foregoing embodiment and may be applied to a semiconductor device including the oxide semiconductor layer 42 that is formed in the through hole and functions as the channel made of the oxide semiconductor, the upper electrode 45 that is formed on the channel and is a conductive oxide, the barrier metal 51 formed on the upper electrode 45, and the lower electrode 27. That is, the configuration of the present embodiment is not necessarily applied to a memory device.

The stacked structure in the foregoing embodiment is merely an example, and for example, a stacked structure that is different from the stacked structure in the embodiment and has the upper electrode 45, the barrier metal 51 on the upper electrode 45, and the insulating film 53 provided adjacent to the upper electrode 45 and becomes an insulator with implantation of any element in addition to the same material as the upper electrode 45 may be employed.

The semiconductor device 1 described in the foregoing embodiment may be a semiconductor device in which a plurality of capacitors 20 and field-effect transistors 40 are formed in the stacking direction.

The semiconductor device 1 described in the foregoing embodiment has a configuration including the capacitor 20 to function as a memory device, but may be a semiconductor device without the capacitor 20.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A semiconductor device comprising:
a channel comprising an oxide semiconductor layer in a through hole;
a first electrode in a first side of the through hole, the first electrode being connected to a first side of the channel;
a second electrode in a second side of the through hole, the second electrode being connected to a second side of the channel; and
an insulating layer having a groove in which the second electrode is accommodated,
the insulating layer comprising a first insulating film and a second insulating film, the first insulating film being closer to the channel than the second insulating film;
the groove extending in a thickness direction, and at least a part of the groove having a depth where at least a part of the groove penetrates through the first insulating film in the thickness direction and reaches the second insulating film, and
the second electrode comprising a metal film and a conductive film stacked on the metal film, the metal film being in contact with at least an inner bottom surface of the groove.

2. The semiconductor device according to claim 1, further comprising:
a semiconductor substrate including:
an array region; and
a non-array region,
wherein the array region comprises the channel, the first electrode, the second electrode, the insulating layer, and a capacitor connected to the channel, and
wherein the non-array region comprises the channel, the first electrode, the second electrode, the insulating layer, and a third electrode connected to the channel,
wherein the array region has an array region groove in the first insulating film of the insulating layer, the array region groove accommodates the second electrode, and
wherein the non-array region has the groove as a non-array region groove having the depth where the at least part of the non-array region groove penetrates through the first insulating film in the thickness direction and reaches the second insulating film.

3. The semiconductor device according to claim 1 or 2, further comprising:
a second insulating layer around the channel;
a control electrode for generating an electric field to be applied to the channel; and
a semiconductor element on the semiconductor substrate and the semiconductor element being electrically connected to the control electrode.

4. The semiconductor device according to any of claims 1 to 3,
wherein the metal film has a bottom that is in contact with the second insulating film.

5. The semiconductor device according to any of claims 1 to 4,
wherein the first insulating film contains one of SiN, SiON, AlOx, and AlN.

6. The semiconductor device according to any of claims 1 to 5,
wherein the recessed groove is one of a dry-etched groove and a wet-etched groove.

7. A semiconductor device comprising:
a channel comprising an oxide semiconductor layer in a through hole;
a first electrode in a first side of the through hole, the first electrode being connected to a first side of the channel;
a second electrode in a second side of the through hole, the second electrode being connected to a second side of the channel; and
an insulating layer having a groove in which the second electrode is accommodated,
the insulating layer comprising a first insulating film and a second insulating film, the first insulating film being closer to the channel than the second insulating film;
the second electrode comprising a metal film and a conductive film stacked on the metal film, the metal film being in contact with at least an inner bottom surface of the groove, and
the metal film comprises at least one of:
a conductive oxide film containing one of titanium oxide, titanium oxynitride, ruthenium oxide, and molybdenum oxide; and
a stack of a titanium layer and a titanium nitride layer.

8. The semiconductor device according to claim 7, further comprising:
a semiconductor substrate including:
an array region; and
a non-array region,
wherein the array region comprises the channel, the first electrode, the second electrode, the insulating layer, and a capacitor connected to the channel, and
wherein the non-array region comprises the channel, the first electrode, the second electrode, the insulating layer, and a third electrode connected to the channel,
wherein the array region has an array region groove in the first insulating film of the insulating layer, the array region groove accommodates the second electrode.

9. The semiconductor device according to claim 7 or 8, further comprising:
a second insulating layer around the channel;
a control electrode for generating an electric field to be applied to the channel; and
a semiconductor element on the semiconductor substrate and the semiconductor element being electrically connected to the control electrode.

10. The semiconductor device according to any of claims 7 to 9,
wherein the first insulating film contains one of SiN, SiON, AlOx, and AlN.

11. The semiconductor device according to any of claims 7 to 10,
wherein the recessed groove is one of a dry-etched groove and a wet-etched groove.

12. The semiconductor device according to claim 8,
wherein the non-array region has the groove as a non-array region groove having the depth where the at least part of the non-array region groove penetrates through the first insulating film in the thickness direction and reaches the second insulating film.
